# EUROPÄISCHE PATENTSCHRIFT

(11) **EP 1 884 008 B1**
(45) Veröffentlichungstag und Bekanntmachung des Hinweises auf die Patenterteilung: **11.05.2011**
(21) Anmeldenummer: 06753908.0
(22) Anmeldetag: 23.05.2006
(51) Int. Cl.: H02J 7/35, H01L 31/04

(54) **SCHUTZSCHALTEINRICHTUNG FÜR EIN SOLARMODUL**
CIRCUIT BREAKER FOR A SOLAR MODULE
DISPOSITIF DE COUPURE DE PROTECTION CONÇU POUR UN MODULE SOLAIRE

(30) Priorität: 24.05.2005 DE 102005024428; 25.07.2005 DE 102005036153
(43) Veröffentlichungstag der Anmeldung: 06.02.2008
(73) Patentinhaber: Fraunhofer-Gesellschaft zur Förderung der angewandten Forschung e.V., 80686 München (DE)
(72) Erfinder: SCHMIDT, Heribert, 79117 Freiburg (DE); BURGER, Bruno, 79104 Freiburg (DE)
(74) Vertreter: Pfenning, Meinig & Partner GbR
(86) Internationale Anmeldenummer: PCT/EP2006/005051
(87) Internationale Veröffentlichungsnummer: WO 2006/125664

(56) Entgegenhaltungen:
- PATENT ABSTRACTS OF JAPAN Bd. 2000, Nr. 09, 13. Oktober 2000 (2000-10-13) -& JP 2000 174308 A (TOSHIBA CORP), 23. Juni 2000 (2000-06-23)
- PATENT ABSTRACTS OF JAPAN Bd. 1997, Nr. 08, 29. August 1997 (1997-08-29) & JP 09 102622 A (NISSIN ELECTRIC CO LTD), 15. April 1997 (1997-04-15)
- PATENT ABSTRACTS OF JAPAN Bd. 2002, Nr. 05, 3. Mai 2002 (2002-05-03) & JP 2002 010520 A (CASIO COMPUT CO LTD), 11. Januar 2002 (2002-01-11)
- WOYTE A ET AL: "Partial shadowing of photovoltaic arrays with different system configurations: literature review and field test results" SOLAR ENERGY, PERGAMON PRESS. OXFORD, GB, Bd. 74, Nr. 3, März 2003 (2003-03), Seiten 217-233, XP004439142 ISSN: 0038-092X

## Beschreibung

Die Erfindung betrifft eine Schutzschalteinrichtung für ein Solarmodul, bei dem eine Mehrzahl von Solarzellen in Reihe geschaltet ist. Eine solche Schutzschalteinrichtung ist aus JP 2000 174 308 bekannt.

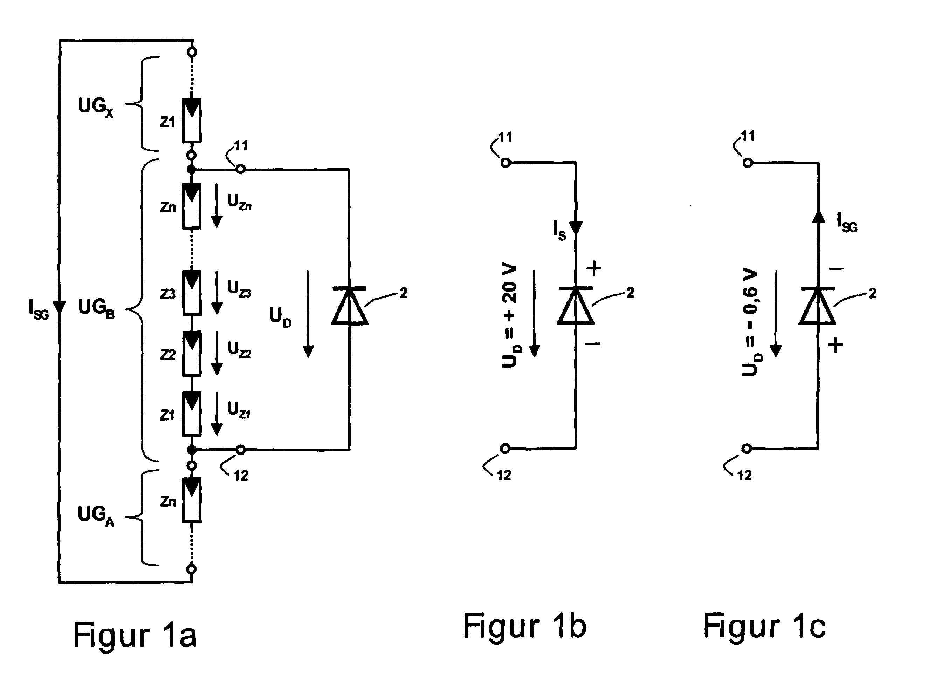

Solarmodule sind allgemein bekannt und bestehen gemäß Fig. 1a üblicherweise aus einer Reihenschaltung von Zellen, die eine Einzelspannung Uz von ca. 0,5 V bis 1 V liefern. Bei einer Teilabschattung einer oder mehrerer Zellen oder auch bei unterschiedlichen Eigenschaften der Zellen, insbesondere des Kurzschlussstroms, kehrt sich bei Belastung die Spannung über den abgeschatteten Zellen um. Im schlimmsten Fall, d.h. bei Kurzschluss des Solargenerators, z.B. beim Betrieb an einem Shunt-Batterie-Laderegler, fällt die Summe der Spannungen aller nicht abgeschatteten Zellen in Sperrrichtung über der abgeschatteten Zelle ab.

Im Folgenden wird unabhängig von der tatsächlichen Ursache der Spannungsumkehr immer der Begriff "Abschattungsfall" benutzt, für den nicht abgeschatteten Betrieb der Begriff "Normalbetrieb".

Die zulässige Sperrspannung einer Solarzelle liegt bei einigen wenigen V bis zu einigen wenigen 10 V. Abhängig von der Anzahl der mit der abgeschatteten Zelle in Reihe geschalteten, nicht abgeschatteten Zellen kann die zulässige Sperrspannung überschritten werden, was zu lokalen Durchbrüchen der Sperrschicht und irreversiblen Schädigungen der Zelle führen kann. Zur Vermeidung dieser unzulässig hohen Sperrspannung ist bekannt, idealerweise eine sog. Bypassdiode parallel zu jeder einzelnen Zelle zu schalten. Dieser Aufwand ist erheblich und nur bei Sonderanwendungen, siehe z.B. die Raumfahrt, tragbar. In handelsüblichen Solarmodulen werden daher gemäß Fig. 1a Untergruppen UG_{A}, UG_{B}, ... UG_{X} von in Serie geschalteten Zellen gebildet, z.B. 18 bis 24, die durch jeweils eine Bypassdiode geschützt werden. Diese werden über Anschlusspunkte 11, 12 mit der jeweiligen Untergruppe verbunden. Der Übersichtlichkeit halber ist in Figur 1a die Bypassdiode nur für die Untergruppe UG_{B} dargestellt.

Im Normalbetrieb liegt gemäß Figur 1b über der Bypassdiode die Summe der Spannungen der zu der Untergruppe gehörenden Zellen Z₁ bis Zₙ, also etwa +15 V bis mehr als + 20 V. Der Sperrstrom I_{S} sollte zur Vermeidung von Verlusten minimal sein. Bei einer vollständigen Abschattung einer oder mehrerer Zellen innerhalb einer Untergruppe fließt gemäß Fig. 1c durch die Bypassdiode 2 der von den außerhalb der Untergruppe liegenden, nicht abgeschatteten Zellen erzeugte Kurzschluss- oder Arbeitspunktstrom I_{SG}. Dieser erzeugt an der Bypassdiode 2, abhängig von der verwendeten Dioden-Technologie, dem durchfließenden Strom und der Diodentemperatur einen Spannungsabfall U_{D} von ca. -0,4 V bis zu mehr als -1 V. Über der abgeschatteten Zelle fällt somit im schlimmsten Fall die Summe der Spannungen aller innerhalb der zugehörigen Untergruppe befindlichen, nicht abgeschatteten Zellen zzgl. des Spannungsabfalls über der Bypassdiode ab.

Die Anzahl der in einer Untergruppe zusammengefassten Zellen wird so gewählt, dass im schlimmsten Fall die zulässige Sperrspannung der abgeschalteten Einzelzelle nicht überschritten wird. Dies führt zu einer typischen Anzahl von ca. 18 bis zu 24 Zellen pro Untergruppe.

Für die bekannte Bypassdiode ergeben sich somit folgende Betriebsbedingungen:
In dem in Fig. 1b dargestellten Normalbetrieb liegt über ihr die Spannung der in einer Untergruppe zusammengefassten Zellen in Sperrrichtung an, typischerweise also ca. +15 V bis zu +20 V. Bei dem in Fig. 1c dargestellten Fall einer vollständiger Abschattung einer Zelle innerhalb der zugehörigen Gruppe fließt der Solargeneratorstrom I_{SG} durch die Bypassdiode und verursacht einen Spannungsabfall U_{D} von ca. -0,4 V bis zu mehr als -1 V. Es wird in der folgenden Beschreibung zur Vereinfachung eine auftretende Sperrspannung von +20 V und eine Durchlassspannung U_{D} von -0,6 V angenommen, wobei andere Werte auftreten können.

Die Bypassdioden sind üblicherweise in einer Anschlussdose untergebracht, die mit dem Solarmodul verbunden ist, und somit Umgebungstemperaturen von ca. -20 °C bis zu mehr als 85 °C ausgesetzt. In einer Dose sind typischerweise zwei oder drei Dioden untergebracht für zwei oder drei Untergruppen UG_{A}, UG_{B} und UG_{C}. Zur Erhöhung der zulässigen Solargeneratorströme I_{SG} können auch mehrere Bypassdioden parallel geschaltet sein.

In den im Stand der Technik eingesetzten Bypassdioden entsteht im Falle einer Abschattung eine relativ große Verlustleistung. Eine solche Verlustleistung kann kurzfristig problemlos von der Diode aufgenommen werden, bei länger andauernden Abschattungen ist es jedoch schwierig, die entstehende Wärmemenge von der Diode und aus der Anschlussdose abzuführen. Dabei ist zusätzlich der Umstand zu berücksichtigen, dass die höchsten Belastungen, d.h. die höchsten Solarströme zumeist bei gleichzeitig hohen Umgebungs- bzw. Modultemperaturen auftreten. Das Problem verschärft sich mit größer werdenden Solarzellen, da diese einen proportional zur Zellfläche ansteigenden Kurzschluss- bzw. Nennstrom liefern.

Der Erfindung liegt daher die Aufgabe zugrunde, eine Schutzschalteinrichtung für ein Solarmodul zu schaffen, die die Funktionen einer Bypassdiode übernimmt, wobei sie wenig Verlustleistung liefert und einfach aufgebaut ist, und eine große und lange Zuverlässigkeit gewährleistet.

Diese Aufgabe wird erfindungsgemäß durch die Merkmale des Hauptanspruchs gelöst.

Dadurch, dass ein steuerbares elektrisches, als Bypasselement dienendes Schaltelement vorgesehen ist, dessen Schaltstrecke parallel zu der Mehrzahl von Solarzellen anschließbar ist und dass eine Versorgungsschaltung eine Steuerspannung zur Ansteuerung der Steuerelektrode bereitstellt, wird eine Bypassschaltung zur Verfügung gestellt, die ohne Schwierigkeit den Kurzschluss- oder Arbeitspunktstrom der abgeschatteten Solarzellen übernehmen kann. Mittels der Versorgungsspannung wird das steuerbare Bypasselement in seiner Funktion so gesteuert, dass wenig Verlustleistung auftritt. Durch die weiterhin vorgesehene Trennschaltung kann die im Normalbetrieb der Solarzellen über der Schaltstrecke des Schaltelementes liegende Spannung zu der Versorgungsschaltung gesperrt werden, während im Abschattungsfall die Trennschaltung die über der Schaltstrecke liegende Spannung zu der Versorgungsschaltung durchschaltet.

Durch die in den Unteransprüchen angegebenen Maßnahmen sind vorteilhafte Weiterbildungen und Verbesserungen möglich.

Besonders vorteilhaft ist, dass die Versorgungsschaltung als Ladeschaltung für einen Energiespeicher ausgebildet ist oder eine solche aufweist, die eine Hochsetzung einer im Abschattungsfall zur Verfügung stehenden Spannung in eine zur Ansteuerung des steuerbaren Bypasselementes höhere Spannung vornimmt. Auf diese Weise kann die über die Schaltstrecke im Abschattungsfall zur Verfügung stehende Versorgungsspannung von -0,6 V verwendet werden, um das steuerbare Bypasselement anzusteuern und ggf. weitere Schaltungen zu versorgen.

In vorteilhafter Weise ist das steuerbare Bypasselement als MOS-Feldeffekttransistor (MOSFET) ausgebildet, wobei die in dem MOSFET inhärent vorhandene Body-Diode kurzzeitig den Solargeneratorstrom vollständig übernehmen kann und bei kleinen Solargeneratorströmen dauerhaft als Bypassdiode genutzt werden kann.

In vorteilhafter Weise wird die dem steuerbaren Bypasselement inhärente Kapazität, bei dem verwendeten MOSFET die Gate-Kapazität, als Energiespeicher der Versorgungsschaltung bzw. Ladeschaltung verwendet, so dass keine zusätzlichen Speicher-Bauelemente notwendig sind.

In besonders vorteilhafter Weise ist die Trennschaltung als invers betriebener Bipolar-Transistor ausgebildet, da dieser im Normalbetrieb konventionell in Kollektorschaltung betrieben wird und somit die im Normalbetrieb auftretende positive Drain-Source-Spannung von 20 V problemlos sperren kann.

Vorteilhaft ist, die Trennschaltung als Feldeffekttransistor, vorzugsweise als selbst leitenden J-FET auszubilden, da dieser einen geringen Einschaltwiderstand aufweist, so dass die nachfolgende Schaltung nahezu verlustfrei mit der Spannung der Schaltstrecke des Bypasselementes, der Drain-Source-Spannung des MOSFET verbunden ist.

In vorteilhafter Weise weist die Versorgungsschaltung und/oder Ladeschaltung einen Transformator mit einer Mitkopplungswicklung und ein erstes elektronisches Schaltelement auf, wobei Schaltelement und Transformator ähnlich einem Sperrschwinger einen Kippvorgang ausüben, bei dem die im Transformator gespeicherte Energie in den Energiespeicher, z.B. die Gate-Kapazität, übertragen wird. Durch diese Maßnahme ist es möglich, aus der geringen Spannung im Abschattungsfall von ca. 0,6 V eine hohe Spannung von etwa 15 V zu erzeugen, wobei die notwenige Energie zur Ladung der Gate-Kapazität schnell, vorzugsweise in einem einzigen Takt, übertragen werden kann.

In besonders vorteilhafter Weise ist das erste elektronische Schaltelement invers geschaltet, so dass es gleichzeitig die Trennschaltung bildet und keine zusätzlichen Bauelemente für die Trennung notwendig sind.

Durch Vorsehen einer ersten Entladeschaltung, die mit der Steuerelektrode des steuerbaren Bypasselementes verbunden ist, wobei die Zeitkonstante der Entladeschaltung so gewählt ist, dass das Verhältnis der Zeit des Leitens des Bypasselementes zu der des Nicht-Leitens groß ist, vorzugsweise größer als 5, ist es möglich, das steuerbare Bypasselement so zu steuern, dass geringe Verlustleistungen auftreten und somit die Wärmeentwicklung gering ist.

Vorteilhaft ist, die erste Entladungsschaltung als nicht linear wirkende aktive Entladungsschaltung auszubilden, die oberhalb einer Schwellenspannung hochohmig und unterhalb der Schwellenspannung niederohmig ist, wobei die Schwellenspannung durch die für die vollständige Durchsteuerung des Bypassschaltelementes benötigte Spannung seiner Steuerelektrode bestimmt ist. Dadurch kann die anfallende Verlustleistung innerhalb des MOSFET weiter verringert werden.

Besonders vorteilhaft ist es, die erste Entladeschaltung mit einem selbstleitenden J-FET zu realisieren, der im Normalbetrieb die Steuerelektrode des Bypassschaltelementes mit einem Referenzpotenzial verbindet und so ein ungewolltes Einschalten des Bypassschaltelementes verhindert, und der im Abschattungsfall zusammen mit einem Netzwerk aus Diode, Kondensator und Entladewiderstand ein Zeitglied bildet, welches das Bypassschaltelement periodisch nach einer definierten Zeit abschaltet. Hierdurch kann die Steuerelektrode des Bypassschaltelementes im durchgeschalteten Zustand immer auf einem optimalen Wert aufgeladen bleiben, wodurch sich die Verlustleistung weiter reduziert.

Ausführungsbeispiele der Erfindung sind in der Zeichnung dargestellt und werden in der nachfolgenden Beschreibung näher erläutert. Es zeigen:
- Figur 1: die Verschaltung von Solarzellen und By- passdioden gemäß dem Stand der Technik so- wie die Diodenspannung im Normalbetrieb und bei Abschattung,
- Figur 2: ein Blockschaltbild der erfindungsgemäßen Schutzschalteinrichtung,
- Figur 3: eine erste schaltungsgemäße Ausgestaltung der erfindungsgemäßen Schutzschalteinrich- tung,
- Figur 4: den zeitlichen Verlauf der Drain-Source- Spannung des steuerbaren Bypasselementes,
- Figur 5: den zeitlichen Verlauf der Gate-Source- Spannung,
- Figur 6: eine zweite schaltungsgemäße Ausgestaltung der erfindungsgemäßen Schalteinrichtung und
- Figur 7: eine dritte schaltungsgemäße Ausgestaltung der erfindungsgemäßen Schutzschalteinrich- tung,
- Figur 8: eine vierte schaltungsgemäße Ausgestaltung der Erfindung und
- Figur 9: den zeitlichen Verlauf der Gate-Source- Spannung des steuerbaren Bypasselementes und der Gate-Source-Spannung des selbstlei- tenden J-FET sowie den zeitlichen Verlauf der Drain-Source-Spannung des steuerbaren Bypasselementes.

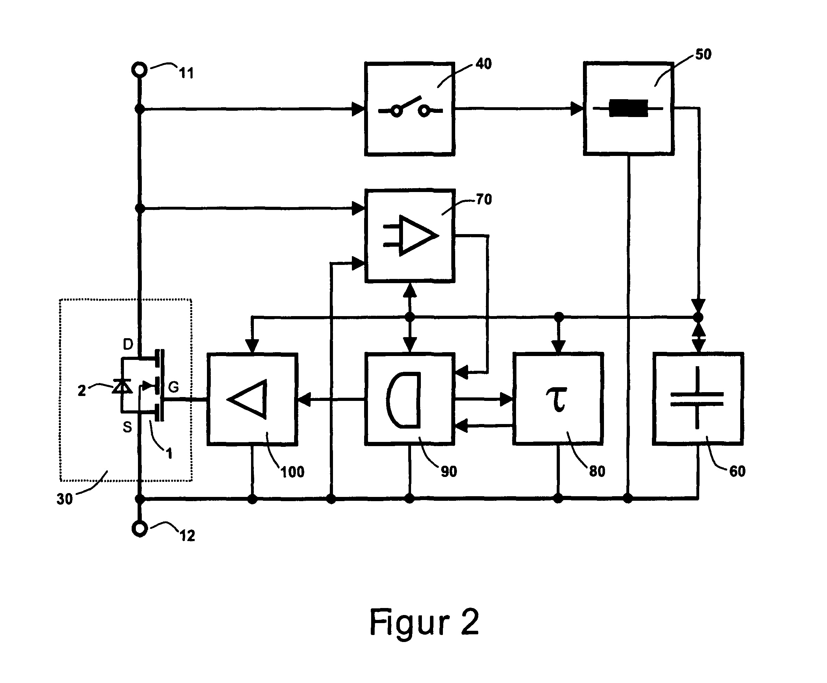

Die in Figur 2 dargestellte Schutzschalteinrichtung weist als wesentlichen Bestandteil einen MOS-Feldeffekttransistor 1 auf, der Bestandteil einer Schaltereinheit 30 ist, die später näher beschrieben wird. Die Drain-Source-Strecke als Schaltstrecke liegt zwischen den Anschlüssen 11 und 12, die mit der Reihenschaltung der Solarzellen des Solarmoduls verbunden sind. Im Normalbetrieb liegt eine positive Spannung von 20 V an der Drain-Source-Strecke, während im Abschattungsfall eine negative Drain-Source-Spannung von 0,6 V vorhanden ist. Die inhärent vorhandene Body-Diode des MOSFET 1 ist mit 2 bezeichnet.
Eine Trennschaltung 40 ist einerseits mit dem Drain-Anschluss des MOSFET 1 und andererseits mit einer Versorgungs- und/oder Ladeschaltung 50 (im Folgenden wird im Wesentlichen von Ladeschaltung gesprochen) verbunden, wobei die Trennschaltung 40 im Normalbetrieb die positive Drain-Source-Spannung von bis zu ca. 20 V sperren muss, während sie im Abschattungsfall den geringen negativen Spannungsabfall von 0,6 V oder auch weniger möglichst verlustarm an die nachfolgende Ladeschaltung 50 weiterleiten muss.

Die Ladeschaltung 50 setzt die im Abschattungsfall hinter der Trennschaltung 40 zur Verfügung stehende geringe negative Gleichspannung in eine zur Ansteuerung des MOSFET 1 und/oder zur Versorgung weiterer Schaltungsteile erforderliche höhere positive Spannung um. Hierbei können Konzepte beruhend auf einer Zwischenspeicherung von Energie in einer Drosselspule oder einem Transformator sowie kapazitiv arbeitende Ladungspumpen zum Einsatz kommen, wobei eine bevorzugte Ausführungsform später beschrieben wird. Die gewandelte Spannung wird in einen Energiespeicher 60, der hier als Kondensator gezeichnet ist, zwischengespeichert, wobei in einer besonders vorteilhaften Weise die Gate-Kapazität des MOSFET 1 direkt als Energiespeicher genutzt wird.

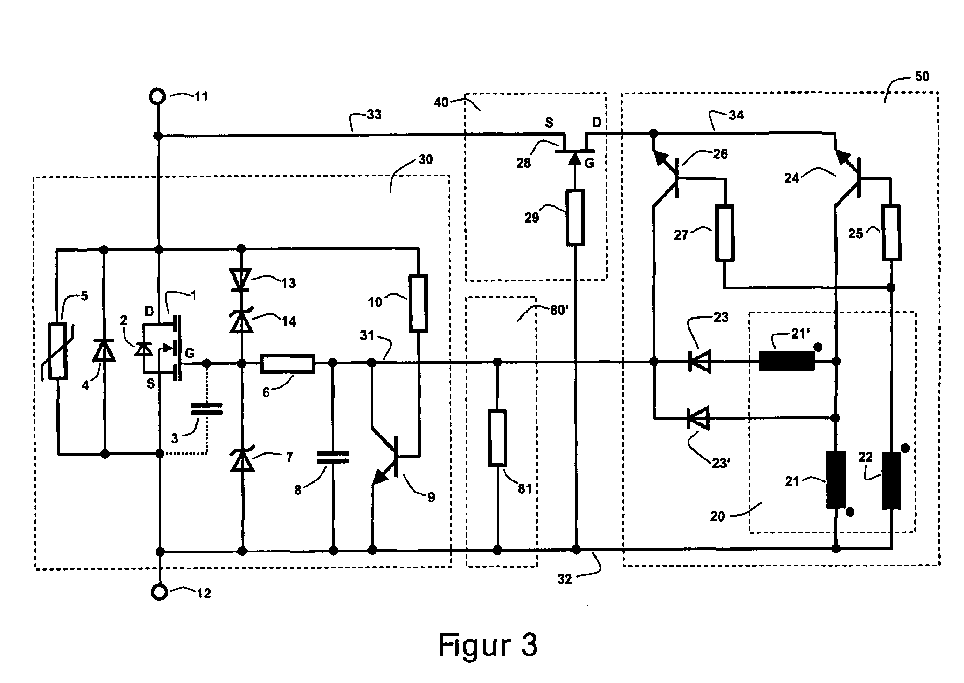

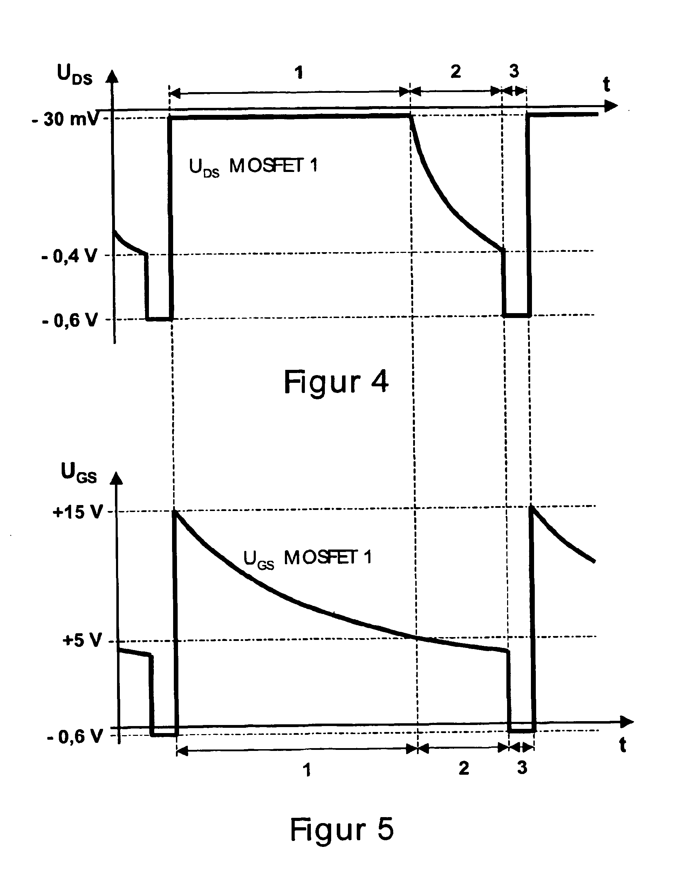

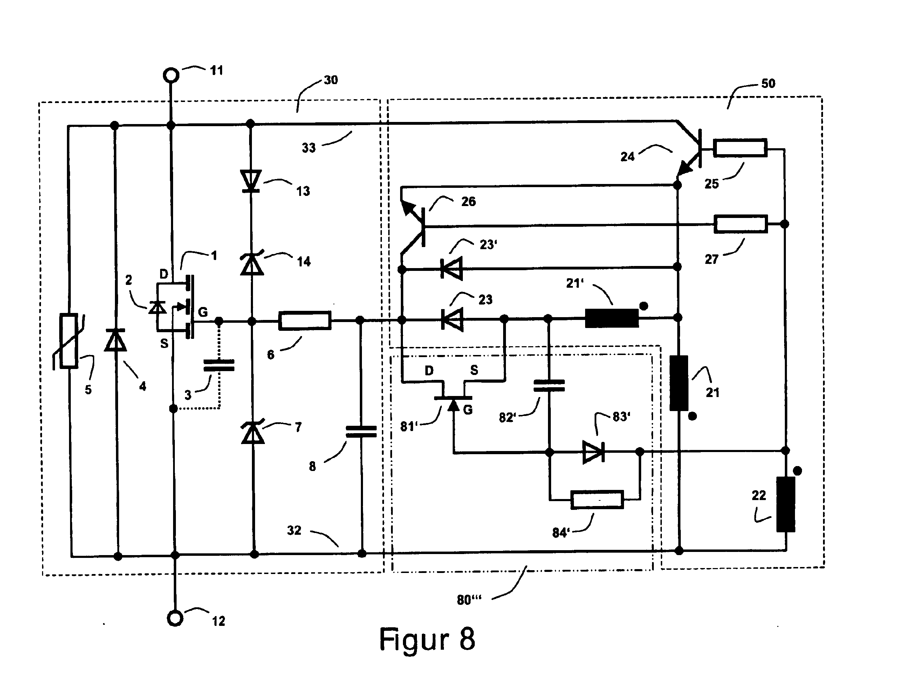

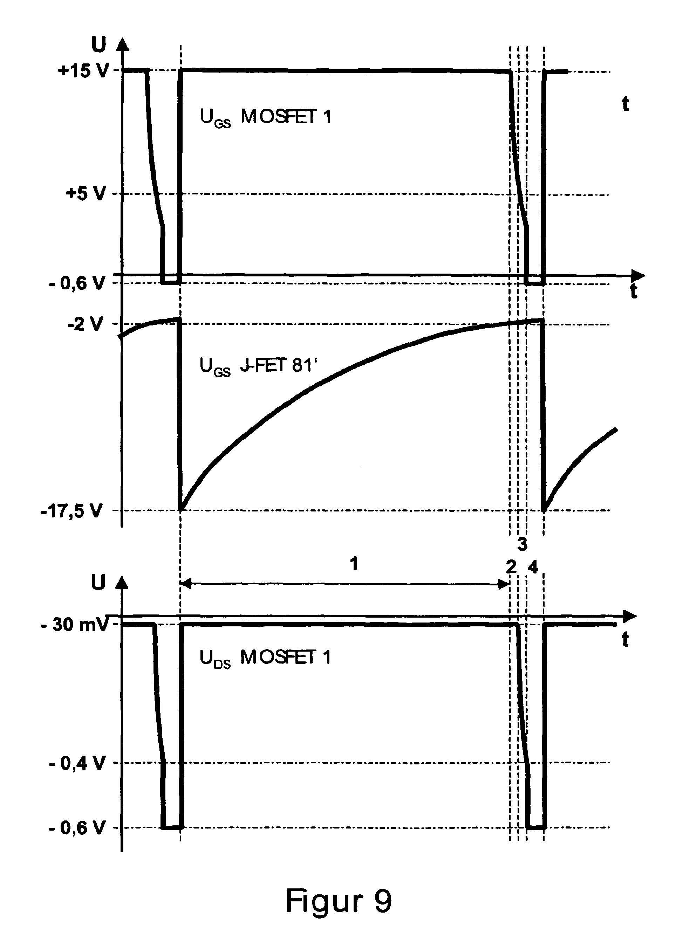

Die Gate-Elektrode G des MOSFET 1 wird mittels einer Zeitgeberschaltung 80 zeitabhängig angesteuert, wobei der MOSFET über den größten Teil der Zykluszeit zur Verringerung der Verlustleistung durchgesteuert ist, ggf. über einen geringeren Zeitraum linear arbeitet und über einen kurzen Zeitraum vollständig gesperrt ist. Der Bypass-Strom des MOSFET 1 fließt dann durch die Body-Diode 2. Bei den Schutzschaltungen gemäß Fign. 3, 6 und 7 wird gemäß Fig. 5 in den ersten beiden Zeitbereichen die Gate-Kapazität des MOSFET entladen, während sie am Ende des dritten Zeitbereichs über die Ladeschaltung geladen wird. Bei der Schutzschaltung nach Fig. 8 erfolgt die Entladung gemäß Fig. 9 nur in den Zeitbereichen 2 und 3, am Ende des vierten Zeitbereichs wird die Kapazität über die Ladeschaltung wieder aufgeladen.

Vorzugsweise ist ein Komparator 70 vorgesehen, der die Drain-Source-Spannung überwacht und im zulässigen Zustand ein Signal an eine Logikschaltung 90 gibt, die gleichfalls das Signal der Zeitgeberschaltung erhält. Überwachungskriterien der Komparatorschaltung 70 sind beispielsweise die Polarität sowie die Höhe der Drain-Source-Spannung des MOSFET 1. Eine Treiberschaltung 100, die wie alle übrigen Schaltungen mit der Versorgungs- oder Ladungsschaltung 50 verbunden ist, steuert das Gate des MOSFET 1 abhängig vom Signal der Logikschaltung an.

Die in der Figur 2 dargestellten Funktionsblöcke sind zur Verbesserung der Übersichtlichkeit aufgeführt, in den weiteren Ausführungsbeispielen ist zu erkennen, dass nicht zwangsläufig alle Funktionsblöcke separat vorhanden sein müssen, es können auch mehrere durch die Blöcke vorgegebenen Funktionen in einem Bauteil zusammengefasst sein.

In Figur 3 ist ein erstes Ausführungsbeispiel der erfindungsgemäßen Schutzschalteinrichtung mit diskreten Bauelementen dargestellt, wobei teilweise die Funktionsblöcke gestrichelt dargestellt sind.Die Schaltereinheit 30 weist, wie schon ausgeführt, den MOSFET 1 mit der Body-Diode 2 sowie inhärent vorhandener Gate-Kapazität 3 auf. Eine erste Zenerdiode 7 ist von der mit dem Anschluss 12 verbundenen Bezugspotentialleitung in Durchgangsrichtung mit dem Gate-Anschluss verbunden. Sie dient zur Begrenzung der Gate-Spannung auf einen zulässigen Wert von z.B. 15 V. Zwischen Bezugspotential 32 und Gate-Steuerleitung 31 ist ein Transistor 9 mit seiner Schaltstrecke geschaltet, dessen Basis über einen hochohmigen Widerstand 10 mit dem Drain-Anschluss des MOSFET 1 verbunden ist. Parallel zu der Schaltstrecke des Transistors 9 liegt ein weiterer Kondensator 8 und zwischen Kondensator 8 und erste Zenerdiode 7 ist in der Steuerleitung 31 ein Vorwiderstand 6 geschaltet. Zwischen Drain-Anschluss und Gate-Steuerleitung 31 liegen eine Diode 13 und eine zweite Zenerdiode 14.

Parallel zur inhärent vorhandenen Body-Diode 2 des MOSFET 1 kann eine weitere Diode 4 geschaltet sein, die bei nicht eingeschaltetem MOSFET 1 einen Teil des oder auch den gesamten Bypass-Strom leitet.

Ein Überspannungs-Schutzelement 5, z.B. ein Varistor oder eine TransZorb-Diode, liegt parallel zum MOSFET 1 und begrenzt extrem hohe, kurzzeitige Spannungsimpulse.

Mit dieser Schutzschaltung wird der MOSFET mit der inhärent vorhandenen Body-Diode 2 vor zu hohen Spannungen an der Drain-Source-Strecke und der Gate-Source-Strecke geschützt. Außerdem ist beim Übergang in den Normalbetrieb, d.h. bei einer positiven Drain-Source-Spannung, ein schnelles Abschalten erforderlich und weiterhin soll ein ungewolltes Einschalten des MOSFET im Normalbetrieb verhindert werden.

Bei einer positiven Drain-Source-Spannung, d.h. beim Übergang zum Normalbetrieb, wird der Transistor 9 über den hochohmigen Basis-Vorwiderstand 10 vollständig durchgesteuert und entlädt die Gate-Kapazität 3 des MOSFET 1 über den niederohmigen Vorwiderstand 6 sehr schnell (Mitkopplung). Weiterhin hält der Transistor 9 die Gate-Source-Spannung über den Vorwiderstand 6 im Normalbetrieb auf nahezu 0 V. Damit wird ein ungewolltes Einschalten, z.B. durch eine von außen induzierte Gate-Spannung, zuverlässig verhindert. Der im Normalbetrieb über den Basis-Vorwiderstand 10 abfließende Verluststrom ist bei entsprechender Dimensionierung vernachlässigbar klein.

Grundsätzlich sind MOSFET begrenzt Avalanche-fest, d.h. bei kurzzeitiger Überschreitung der maximal zulässigen Drain-Source-Spannung, z.B. größer als 60 V, bei einem für 40 V spezifizierten MOSFET wird der MOSFET leitend und begrenzt die Spannungsspitze ohne Schaden zu nehmen. Bei dieser Betriebsart kann aber der zulässige Arbeitsbereich verlassen werden und das Bauteil einem verstärkten Stress unterliegen. Daher wird über die Zenerdiode 14 und die Diode 13 der MOSFET beim Auftreten einer überhöhten Spannung gezielt über seine Gate-Source-Strecke angesteuert, wobei beim Überschreiten der Zenerspannung der Zenerdiode 14 das Gate auf ein positives Potential angehoben wird und der MOSFET 1 im linearen Bereich betrieben wird. Um bei leitendem Transistor 9 eine positive Gate-Spannung aufbauen zu können, ist der Vorwiderstand 6 erforderlich.

Der über den Vorwiderstand 6 zur inhärent vorhandenen Gate-Kapazität 3 parallel geschaltete Kondensator 8, der typischerweise eine höhere Kapazität als die Gate-Kapazität 3 aufweist, verringert die Störempfindlichkeit der Schaltung. Der Kondensator wird vorteilhafterweise auf der vom Gate abgewandten Seite des Vorwiderstandes 6 angeschlossen, da dann im Falle einer transienten Überspannung nur die vergleichsweise niedrige Gate-Kapazität 3 über die Zenerdiode 14 und die Diode 13 geladen werden muss.

Wie schon oben ausgeführt, hat die Trennschaltung 40 die Aufgabe, die im Normalbetrieb positive Drain-Source-Spannung von 20 V von der nachfolgenden Schaltung zu trennen und die im Abschattungsfall negative Drain-Source-Spannung von 0,6 V verlustarm an die nachfolgenden Schaltungsteile weiterzuleiten. Die in Figur 3 dargestellte Trennschaltung 40 weist einen selbstleitenden n-Kanal Junction-FET (J-FET) 28 auf, dessen Source-Elektrode mit dem Drain-Anschluss des MOSFET 1 verbunden ist, dessen Drain-Elektrode an die nachfolgende Versorgungs- oder Ladeschaltung 50 angeschlossen ist und dessen Gate-Elektrode über einen hochohmigen Gate-Widerstand 29 mit der Bezugspotentialleitung 32 verbunden ist. Dieser Widerstand 29 begrenzt den Strom durch die Gate-Dioden bei einer positiven Gate-Drain- oder Gate-Source-Spannung größer als 0,5 V, wie sie im Abschattungsfall auftritt. Zum Sperren benötigt der niederohmige J-FET 28 eine sowohl gegenüber Drain als auch Source negative Gate-Spannung von ca. 5 V. Dies wird im Normalbetrieb für die Source-Gate-Strecke direkt erreicht. Für die Drain-Gate-Strecke kann das hingegen nur dann erreicht werden, wenn das Drain-Potential einen positiven Wert annimmt. Hierzu ist es erforderlich, dass die nachfolgende Versorgungs- bzw. Ladeschaltung 50 eine Sperrspannung in Höhe der Schwellenspannung des J-FET aufnehmen kann, also etwa 5 V. Diese besondere Eigenschaft wird durch die unten beschriebene Ladeschaltung 50 gewährleistet.

Anstelle des beschriebenen J-FETs 28 kann auch ein selbstleitender MOSFET eingesetzt werden, der ein ähnliches Verhalten aufweisen, wobei dann jedoch eine Strombegrenzung über den Widerstand 29 nicht notwendig ist, da die Gate-Isolation typischerweise ± 20 V aufnehmen kann.

Die Versorgungs- und/oder Ladeschaltung 50 hat zur Aufgabe, eine negative Eingangsspannung von 0,6 V in eine zur Ansteuerung des MOSFET 1 ausreichende positive Ausgangsspannung von z.B. 15 V umzusetzen. Unter Berücksichtigung des mit zunehmender Temperatur abnehmenden Spannungsabfalls über der Body-Diode 2 des MOSFET 1 sowie eventuell auftretender Spannungsabfälle in der Trennschaltung 40, muss ein sicherer Anlauf bereits bei Spannungen von sogar kleiner als 0,4 V gewährleistet sein. Weiterhin muss die Ladeschaltung sehr robust und mit minimalem Aufwand zu erstellen sein. Sie übernimmt zusätzlich die Funktionen des Komparators 70 sowie teilweise der Zeit- und Treiberschaltungen 80, 100 aus Figur 2.

Die Ladeschaltung 50 gemäß Figur 3 weist einen in Emitterschaltung betriebenen Transistor 24 auf, dessen Emitter mit dem Drain-Anschluss des J-FET 28 und dessen Kollektor mit der Primärwicklung 21 eines Wandlertransformators 20 verbunden ist. Die Basis des Transistors 24 ist über einen Vorwiderstand 25 an eine Mitkopplungswicklung 22 angeschlossen. In Reihe mit der Primärwicklung 21 liegt eine Ausgangswicklung 21', wodurch der Wandlertransformator 20 als Spartransformator geschaltet ist. Der Kollektor des Transistors 24 ist zwischen Primärwicklung 21 und Ausgangswicklung 21' angeschlossen. Die Ausgangswicklung 21' ist über eine Gleichrichterdiode 23 und den Vorwiderstand 6 mit der Gate-Kapazität 3 bzw. direkt mit dem zusätzlichen Kondensator 8 verbunden. Eine weitere Diode 23' verbindet das Ende der Primärwicklung mit dem zusätzlichen Kondensator 8.

Zusätzlich weist die Ladeschaltung 50 einen Transistor 26 auf, dessen Emitter am Drain-Anschluss des J-FET 28, dessen Kollektor zwischen Diode 3 und Vorwiderstand 6 und dessen Basis über einen Vorwiderstand 27 mit dem Anschluss der Mitkopplungswicklung 22 verbunden ist.

Ein Entladewiderstand 81, der Bestandteil einer Zeitgeberschaltung 80' sein kann, ist zwischen Bezugspotentialleitung 32 und Gate-Steuerleitung 31 geschaltet.

Die Funktionsweise, insbesondere der Versorgungs- oder Ladeschaltung, sowie das Schaltverhalten des MOSFET 1 wird unter Bezugnahme auf die zeitabhängigen Spannungsverläufe nach Figur 4 und 5 beschrieben. Bei Abschattung und eingeschaltetem MOSFET 1 fällt über der Drain-Source-Strecke, abhängig vom Einschalt-Widerstand (R_{DSon}) des MOSFET 1 und dem momentanen Solargeneratorstrom, eine negative Spannung von wenigen Millivolt, z.B. -30 mV ab. Dies ist in Figur 4 mit dem Bereich (1) bezeichnet. Da die dann über die Trennschaltung 40 gelieferte Spannung nicht ausreicht, ist entsprechend auch die Versorgungsschaltung 50 nicht aktiv. Der Entladewiderstand 81 entlädt langsam, z.B. innerhalb von 100 ms (Bereich (1)), die Gate-Kapazität 3 des MOSFET 1, die entsprechend Figur 4 auf z.B. 15 V geladen war. Wird die Schwellenspannung des MOSFET 1 bei z.B. 5 V Gate-Source-Spannung erreicht, so geht dieser vom vollständig durchgesteuerten in den linearen Bereich über (Bereich (2)), und die Drain-Source-Spannung steigt entsprechend Figur 4 langsam an. Ohne die weiter unten beschriebene Nachladung der Gate-Source-Kapazität 3 über die Ladeschaltung 50 würde der MOSFET 1 in den vollständig gesperrten Zustand übergehen, wobei in diesem Falle der Solargeneratorstrom vollständig durch die Body-Diode 2 fließt, verbunden mit einem negativen Spannungsabfall von ca. 0,4 V bis zu ca. 1 V.

Bei einer Spannung von ca. 0,3 V bis 0,4 V zwischen der Leitung 34 und der Bezugspotentialleitung 32, d.h. dem Drain-Anschluss der Trennschaltung 40, fließt ein ausreichend großer Basisstrom im Transistor 24, um einen merklichen Kollektorstrom und somit Strom durch die Primärwicklung 21 des Transformators 20 hervorzurufen. Hierdurch wird in der Mitkopplungswicklung 22 eine Spannung induziert, die sich aufgrund des Wicklungssinnes zu der Spannung zwischen den Leitungen 32 und 34 addiert und somit den Basisstrom verstärkt, wodurch ein Kippvorgang einsetzt. Der Transistor 24 wird vollständig durchgeschaltet und es baut sich entsprechend der Induktivität der Primärwicklung 21 und der über der Primärwicklung anliegenden Spannung, die im Wesentlichen der zwischen den Leitungen 32, 34 anliegenden Spannung entspricht, ein zeitlich zunehmender Primärstrom auf.

Gerät der Kern des Transformators 20 in die Sättigung oder reicht der Basisstrom des Transistors 24 nicht mehr zur vollständigen Durchsteuerung aus, so kehrt sich die Mitkopplung um und der Transistor 24 wird schlagartig gesperrt. Die in der Transformatorinduktivität gespeicherte Energie wird über die Primärwicklung 21 sowie die Ausgangswicklung 21' und die Gleichrichterdiode 23 in die Gate-Kapazität 3 sowie den zusätzlichen Kondensator 8 übertragen. Dies ist am Ende des Bereichs (3) bzw. am Anfang des Bereichs (1) der Figuren 4 und 5 zu erkennen. Der MOSFET 1 schaltet somit ein und weist, wie beschrieben, entsprechend seines Innenwiderstandes nur noch einen negativen Spannungsabfall von wenigen Millivolt auf. Die Ladeschaltung 50 wird dann nicht ausreichend mit Spannung versorgt und ist nicht aktiv. Der Transformator 20 wird so dimensioniert, dass die in ihm gespeicherte Energie ausreicht, bereits mit einem Wandlertakt die Gate-Kapazität 3 bzw. den Kondensator 8 auf den Sollwert von z.B. 15 V aufzuladen.

Bei einem realen Transformator führt die unvermeidliche Streuinduktion der Transformatorwicklung 21 beim schnellen Abschalten des Transistors 24 zu einer Überspannungsspitze am Transistor 24, die diesen schädigen kann. Die Diode 23' verhindert diese Spitze, indem sie den im Abschaltaugenblick in der Transformatorwicklung fließenden Strom in den dann ungeladenen Kondensator weiter fließen lässt.

Es sei nochmals darauf hingewiesen, dass sich "Takt" immer auf die Ladeschaltung 50, der Begriff "Zyklus" sich immer auf die Gesamtschaltung bezieht. Der Ladetakt besteht aus zwei Phasen: Die erste Phase wurde oben beschrieben und sie beginnt und erstreckt sich über die Dauer des Bereichs (3) des Gesamtzyklus. Der Kippvorgang selbst dauert dabei nur wenige µs, der wesentliche Teil der Zeit besteht in dem "langsamen" Anstieg des Stromes bis zum Ende des Bereichs (3). Dann setzt die zweite Taktphase ein, in welcher die Energie aus dem Transformator zu den Kapazitäten übertragen wird. Dieser Vorgang liegt auf der abfallenden Flanke, also teilweise im Bereich (3) und im Bereich (1) des nachfolgenden Zyklus. Dieser Umladevorgang dauert aber insgesamt auch nur wenige µs.

Wie aus der oben beschriebenen Funktionsweise ersichtlich ist, übernimmt der Transistor 24 mit seiner Basis-Emitterstrecke neben der Schaltfunktion auch die Funktion des Komparators 70 aus Figur 2, d.h. er arbeitet nur, wenn die anliegende Drain-Source-Spannung groß genug ist. Vorteilhafterweise wird der Transistor 24 daher thermisch mit dem MOSFET 1 gekoppelt. Da beide Bauelemente auf Silizium-Technologie beruhen, ändern sich die Durchlassspannungen der Body-Diode und auch der Basis-Emitterdiode gleichsinnig, so dass bei allen Temperaturen eine sichere Funktion der Schaltung gewährleistet ist.

Wenn die negative Drain-Source-Spannung des MOSFET bzw. die der Ladeschaltung 50 gelieferte Spannung z.B. aufgrund des Innenwiderstandes der Trennschaltung 40 nicht ausreichend groß ist, läuft der oben beschriebene Kippvorgang bzw. Wandlertakt, der durch den Bereich (3) gegeben ist, nicht zwangsläufig vollständig ab. Damit kann, insbesondere bei kleinen Solargeneratorströmen, die Gate-Kapazität 3 des MOSFET 1 bzw. der Kondensator 8 nicht vollständig geladen werden.

Um einen stabilen Betrieb der Schutzschalteinrichtung zusätzlich sicherzustellen, wird beim Einsetzen des Kippvorgangs das Gate des MOSFET 1 über den dann eingeschalteten Transistor 26 sehr schnell entladen, wie aus Figur 5, Bereich (3) zu erkennen ist. Der MOSFET 1 sperrt momentan und die Drain-Source-Spannung steigt gemäß Fig. 4 schnell von ca. -0,4 V dem Schwellenwert des Kippvorgangs, auf ca. -0,6 V, die Durchlassspannung der Body-Diode 2, an. Durch den Transistor 26 entsteht also eine zusätzliche Mitkopplung. In der zweiten Phase des Wandlertaktes wird der Transistor 26 über die dann negative Spannung an der Mitkopplungswicklung 22 vollständig gesperrt, so dass die Gate-Kapazität 3 bzw. der Kondensator 8 geladen werden können.

Der Gesamtzyklus der Schaltung nach Figur 3 setzt sich entsprechend den Figuren 4 und 5 aus einer ersten, langen Phase (100 ms) zusammen, in der der MOSFET 1 vollständig durchgesteuert ist, einer zweiten, kürzeren Phase (20 ms), in welcher er in den linearen Bereich gelangt und die Drain-Source-Spannung langsam bis auf ca. -0,4 V ansteigt und einer dritten, kurzen Phase, in der er durch die Mitkopplungsschaltung für eine kurze Zeit (z.B. 1 ms) vollständig abgeschaltet wird. Die in der zweiten und dritten Phase anfallende Wärmemenge stellt aber keinerlei Problem dar und kann konventionell abgeführt werden.

Wie schon mehrfach ausgeführt, steigt im Normalbetrieb des Moduls die Drain-Source-Spannung des MOSFET auf positive Werte von ca. 15 V bis ca. 20 V an. Damit der in der Trennschaltung 40 eingesetzte J-FET 28 sperrt, müssen sowohl dessen Drain- als auch dessen Source-Anschluss um ca. 5 V positiv gegenüber dem Gate-Anschluss sein, anderenfalls würde ein nicht zulässiger Verluststrom in die Ladeschaltung 50 fließen. Da bei der Schaltung nach Figur 3 die Emitter-Basisstrecken der Transistoren 24 und 26 für positive Spannungen an der Leitung 34 in Sperrrichtung liegen und sie auch eine Sperrspannung von bis zu ca. 5 V aufnehmen können, kann das Drain-Potential des J-FET 28 bis auf 5 V ansteigen und der J-FET 28 damit, wie gefordert, vollständig sperren.

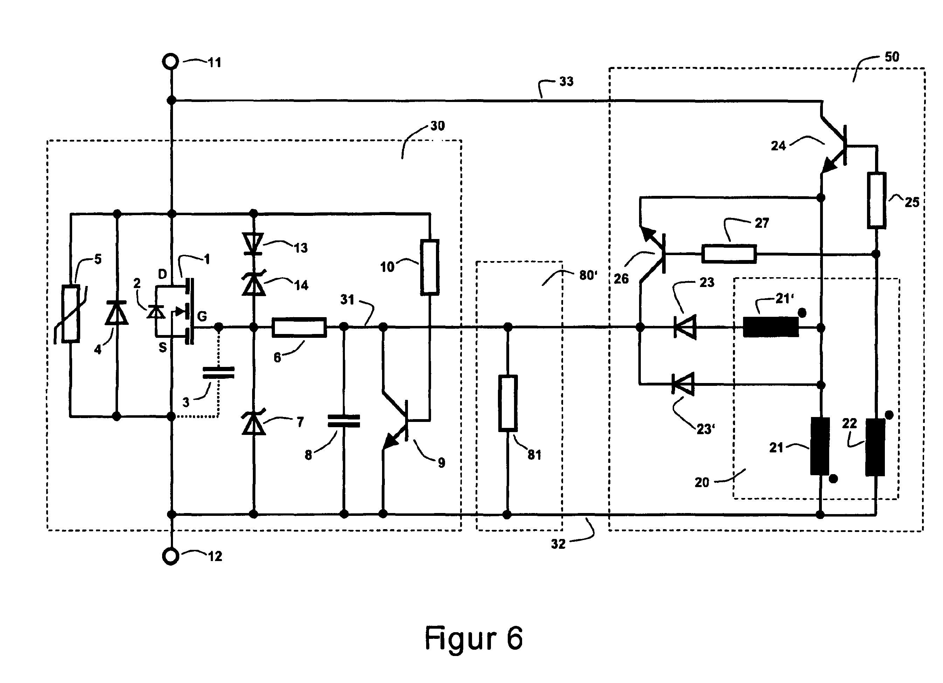

In Figur 6 ist ein weiteres Ausführungsbeispiel dargestellt, das eine Vereinfachung der in Figur 3 dargestellten Schaltung dadurch erreicht, dass die Funktionen der Trennschaltung 40 und des Transistors 24 der Versorgungs- bzw. Ladeschaltung 50 zusammengefasst werden. Ansonsten entspricht die Schaltung der nach Figur 3 und auch die Spannungsdiagramme nach Figur 4 und Figur 5 sind anwendbar.

Wie zu erkennen ist, wird der Transistor 24 invers betrieben. Werden bei einem Bipolar-Transistor Emitter und Kollektor vertauscht, so bleiben die prinzipiellen Transistoreigenschaften erhalten, im inversen Betrieb vermindert sich jedoch die Stromverstärkung um etwa den Faktor 30. Diese Eigenschaft wird mit einem entsprechend niederohmigen Basis-Vorwiderstand 25 Rechnung getragen. In der Praxis reicht zur Strombegrenzung u.U. bereits der ohmsche Widerstand der Mitkopplungswicklung 22 aus, so dass kein konzentriertes Bauelement 25 eingesetzt werden muss. Der Inversbetrieb des Transistors 24 bringt den großen Vorteil mit sich, dass dieser im Normalbetrieb des Solarmoduls in Kollektorschaltung betrieben wird, wobei seine Basis und auch der Emitter gleichspannungsmäßig auf dem Bezugspotential 32 liegen. In dieser Betriebsart kann der Transistor problemlos die auftretende Spannung von 20 V aufnehmen, auch ist es möglich, einen spannungsfesten Transistortyp einzusetzen, der etwaigen Überspannungspulsen besser widersteht. Eine Oszillation der Versorgungs- oder Ladeschaltung ist wegen der in diesem Betriebsfall als Gegenkopplung wirkende Mitkopplungswicklung 22 ausgeschlossen.

Der Transistor 26 wird weiterhin konventionell betrieben, und seine Funktion entspricht derjenigen in Fig. 3. Sein Emitter ist jedoch mit dem Emitter des Transistors 24 verbunden. Damit kann im durchgeschalteten Zustand des Transistors 24 das Gate des MOSFET 1 schnell über Transistor 26 entladen werden, wobei er bei dieser Art der Verschaltung in der Leitendphase des MOSFET 1 und auch im Normalbetrieb des Moduls keine negativen Sperrspannungen aufnehmen muss.

Wie oben beschrieben, wird bei den Schaltungen entsprechend Figur 3 und Figur 6 die notwendige Energie zur Ladung der Gate-Kapazität 3 bzw. der Kapazität 8 in einem einzigen Takt, d.h. in einem einzigen Kippvorgang des Wandlertransformators 20 und des Transistors 24 übertragen. Die Ladeschaltung kann die Energie aber auch in mehreren Takten übertragen, wobei sie die Gate-Kapazität des MOSFET 1 oder einen Energiespeicher in mehreren Takten auflädt und dann abschaltet.

Schließlich kann der schon erwähnte unvollständige Aufladevorgang der Gate-Kapazität bzw. des Kondensators 8 auch durch eine entsprechende Dimensionierung, z.B. des Basis-Vorwiderstandes 25, zum Prinzip erhoben werden, um den dauerhaft linearen Bereich des MOSFET 1 zu erreichen. In dieser Betriebsart dient der Transistor 24 als Regler für die Drain-Source-Spannung. Der MOSFET 1 wird hierbei nicht vollständig durchgesteuert, sondern über den Transistor 24 als Regler im linearen Betrieb gehalten. Dabei fällt im Abschattungsfall eine negative Spannung von ca. 0,3 V bis 0,4 V über der Drain-Source-Strecke ab, die ausreicht, die Versorgungs- oder Ladeschaltung 50 kontinuierlich laufen zu lassen. Bei diesem Konzept sind die Verluste innerhalb des MOSFET 1 größer als bei einem vollständig durchgeschalteten MOSFET. Von Vorteil ist aber, dass bei diesem linear arbeitendem MOSFET keine Sprünge in der Solargeneratorspannung bzw. dem Solargeneratorstrom auftreten.

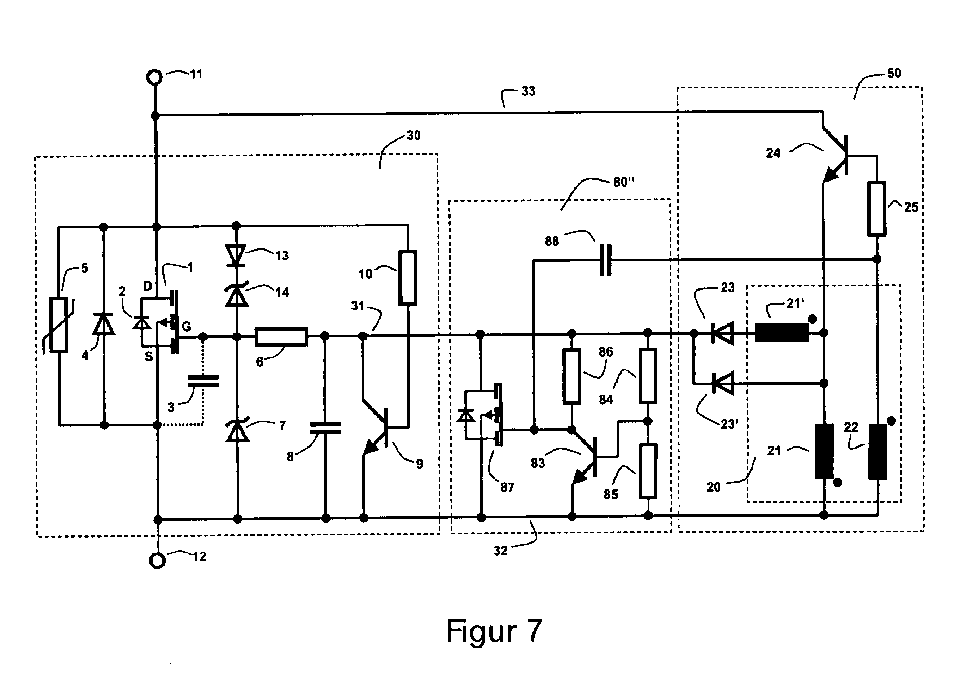

Um die anfallende Verlustleistung innerhalb des MOSFET 1 weiter zu verringern, kann der zeitweilige Betrieb im linearen Bereich des MOSFET entsprechend dem Bereich (2) in Figur 4 und Figur 5 verhindert werden. Eine solche Schaltung ist in Figur 7 dargestellt, die sich von der Schaltung nach Figur 3 bzw. Figur 6 durch die mit 80" bezeichnete Entladeschaltung unterscheidet. Bei den Schaltungen nach Figur 3 und Figur 6 wird der Abschaltzeitpunkt des MOSFET 1 von dem durch seine Gate-Kapazität 3, dem ggf. vorhandenen Kondensator 8 sowie dem Entladewiderstand 81 gebildeten Zeitglied bestimmt. Anstelle des Entladewiderstandes 81 wird eine nicht linear wirkende, aktive Gate-Entladeschaltung eingesetzt. Diese hat die Eigenschaft, dass sie oberhalb einer bestimmten Schwellenspannung hochohmig ist, beim Unterschreiten der Schwellenspannung jedoch deutlich niederohmiger wird. Eine Schaltung mit dieser Eigenschaft lässt sich z.B. durch eine Schmitt-Trigger-Schaltung realisieren. Wenn der Umschaltpunkt dieser Trigger-Schaltung, d.h. die Kippschwelle der Gate-Entladeschaltung 80", höher gelegt wird als die höchste zur vollständigen Durchsteuerung des MOSFET 1 benötigte Gate-Spannung, z.B. auf 6 V oder größer, so wird diese nach einer Aufladung durch die Ladeschaltung 50 zunächst langsam absinken, um nach dem Unterschreiten der Trigger- oder Kippschwelle schnell abzusinken und einen neuen Ladetakt auszulösen. Mit einer solchen Schaltung wird der Betrieb des MOSFET 1 im linearen Bereich, der in Figur 4 und Figur 5 mit Bereich (2) bezeichnet ist, vermieden und die Verlustleistung nochmals gesenkt.

Bei dieser Schaltung 80" ist ein Kleinsignal-MOSFET 87 zwischen Gate-Steuerleitung 31 und Bezugspotentialleitung 32 geschaltet, dessen Gate-Anschluss mit dem Kollektor eines Transistors 83 verbunden ist, dessen Emitter wiederum auf dem Bezugspotential 32 liegt. Der Basisanschluss ist mit einem Spannungsteiler 84, 85 zwischen Gate-Steuerleitung 31 und Bezugspotentialleitung 32 verbunden. Schließlich ist ein Widerstand 86 zwischen Leitung 31 und Gate-Anschluss des MOSFET 87 geschaltet. Vom Kollektoranschluss des Transistors 83 ist ein Kondensator 88 mit der Mitkopplungswicklung 22 verbunden.

Bei hohen Gate-Spannungen des MOSFET 1 wird der Transistor 83 über den Spannungsteiler 84, 85 vollständig durchgesteuert. Sein Kollektorpotential und somit auch das Gate-Potential des MOSFET 87 liegen daher nahe beim Bezugspotential 32 und der MOSFET 87 ist somit gesperrt.

Die Gate-Kapazität 3 des MOSFET 1 sowie der Kondensator 8 werden über die hochohmigen Widerstände 84, 85 sowie 86 langsam entladen. Unterschreitet die Gate-Spannung vom MOSFET 1 einen Mindestwert, so beginnt Transistor 83 zu sperren und die Gate-Spannung des MOSFET 87 steigt an. Wird dessen Schwellenspannung von z.B. ca. 1 ... 2 V bei einem Kleinsignal-MOSFET 87 erreicht, so wird seine Drain-Source-Strecke niederohmig und die Gate-Kapazität 3 bzw. der Kondensator 8 werden schnell entladen. Dadurch sinkt der Basisstrom für den Transistor 83 weiter und es setzt ein Kippvorgang ein. Dieser Kippvorgang wird dadurch unterstützt, dass ab einer bestimmten Drain-Source-Spannung des MOSFET 1 die Versorgungs- bzw. Ladeschaltung 50 wie oben beschrieben anläuft. Dabei steigt im ersten Taktabschnitt die Spannung an der Mitkopplungswicklung 22 auf positive Werte an. Dieser Anstieg überträgt sich über den Koppelkondensator 88 auf das Gate des MOSFET 87, wodurch der Mitkopplungsvorgang nochmals verstärkt wird und die Gate-Kapazität 3 bzw. der Kondensator 8 vollständig entladen werden. Hierdurch wird auch der MOSFET 1 sehr schnell vollständig gesperrt.

Aufgrund der zusätzlichen Mitkopplung über den Kondensator 88 kann der in Figur 6 gezeigte Mitkopplungszweig über den Transistor 26 und den Vorwiderstand 27 entfallen.

In der zweiten Phase des Ladetaktes wird der MOSFET 87 über den mit dem Kondensator 88 übertragenen negativen Spannungssprung an der Mitkopplungswicklung 22 vollständig gesperrt, so dass die Gate-Kapazität 3 bzw. der Kondensator 8 wieder geladen werden können. Die Figur 8 zeigt eine weitere, besonders vorteilhafte Ausführung der Schutzschaltung. Sie entspricht im Wesentlichen der Schaltung nach Fig. 6, wobei der Transistor nebst Vorwiderstand 10 entfallen und die passive Entladeschaltung 80' durch eine aktive Entladeschaltung 80''' ersetzt wurde.

Kernpunkt der aktiven Entladeschaltung 80''' ist der selbstleitende J-FET 81'. Er ersetzt zum einen den Transistor 9 nebst Vorwiderstand 10, indem er im Normalbetrieb des Solarmoduls das Gate des MOSFET 1 über den Vorwiderstand 6 und die Wicklungen 21' und 21 des Transformators zum Bezugspotenzialleiter 32 hin verbindet. Hierdurch wird ein ungewolltes Einschalten des MOSFET 1 durch von außen induzierte Gate-Spannungen oder auch Leckströme der Dioden 13 und 14 sicher unterbunden. Zum anderen ermöglicht er eine optimale Ansteuerung des MOSFET 1 gemäß Fig. 9, was zu einer weiteren Verminderung der Verlustleistung im Bypassschaltelement führt.

Im Unterschied zu den zuvor beschriebenen Schaltungen wird in der Schaltung nach Fig. 8 das Gate des MOSFET 1 nach dem Aufladevorgang nicht durch einen Widerstand entladen, sondern die Gate-Spannung U_{GS} behält gemäß Fig. 9 während des gesamten Zeitraums 1 ihren vollen Wert bei. Hierdurch ist der MOSFET in dieser Zeit sehr niederohmig, und die Verlustleistung ist entsprechend gering. Der Abschaltzeitpunkt des MOSFET 1 wird durch eine Zeitkonstante des aus dem Kondensator 82' und dem Widerstand 84' gebildeten Zeitgliedes bestimmt. In der Ladephase der Kondensatoren 8 und 3 am Ende des Zeitraumes 4 wird auch der Kondensator 82' über die Diode 83' auf die Summe der Spannungen an den drei Wicklungen 21, 21' und 22 geladen, in diesem Beispiel auf 17,5 V. Springt nach der Entmagnetisierung des Transformators 20 die Spannung der Wicklungen 21 und 21' auf Null zurück, so springt das Potential am Gate des J-FET 81' auf einen Wert von - 17,5 V. Der J-FET wird somit vollständig gesperrt, und es kann im Idealfall keine Ladung von den Kondensatoren 8 und 3 abfließen. Durch den Widerstand 84' wird der Kondensator 82' langsam entladen, z.B. innerhalb von 100 ms. Erreicht die Gatespannung des J-FET 81' dessen Schwellenspannung (in diesem Beispiel - 2V), so wird der J-FET niederohmig und entlädt die Kondensatoren 8 und 3 über die Wicklungen 21' und 21, wodurch die Gate-Spannung U_{GS} des MOSFET 1 sehr schnell sinkt, was in Fig. 9 im Zeitabschnitt 2 dargestellt ist. Unterschreitet diese Spannung die Schwellenspannung des MOSFET 1, so beginnt dieser zu sperren, und seine Drain-Source-Spannung U_{DS} steigt gemäß Fig. 9, Abschnitt 3, schnell an, Wird ein Wert von ca. - 0,4 V erreicht, so setzt, wie bei den bisherigen Schaltungen beschrieben, der Kippvorgang der Ladeschaltung 50 ein, verbunden mit einer sehr schnellen weiteren Entladung der Kondensatoren 8 und 3 durch den Transistor 26. Es folgt der Abschnitt 4, in welchem der Transistor 24 vollständig leitend ist und Energie im Transformator 20 gespeichert wird. Am Ende dieses Abschnitts erfolgt die erneute Aufladung der Kondensatoren 8 und 3 sowie 82'.

Dadurch, dass der MOSFET 1 für den überwiegenden Teil der Zykluszeit vollständig durchgesteuert ist und der Zeitraum im sperrenden Zustand weniger als 1 % der Zykluszeit ausmacht, wird die Verlustleistung bei der Schaltung nach Fig. 8 gegenüber den anderen Schaltungen nochmals reduziert.

Die beschriebenen Schaltungen können selbstverständlich alle mit komplementären Halbleitertypen aufgebaut werden.

Neben der Funktion als verlustarmes Bypass-Element kann der MOSFET 1 als Zusatzfunktion auch ein Kurzschließen der Solargeneratorspannung bei der Installation, im Falle einer Inspektion oder im Brandfall übernehmen. Hierzu werden beispielsweise über eine Steuerleitung die Gate-Anschlüsse aller MOSFET innerhalb eines Solargenerators mit einer Steuerspannung beaufschlagt, so dass die Spannung eines jeden einzelnen Moduls kurzgeschlossen wird. Hierdurch ist eine gefahrlose Berührung der spannungsführenden Teile und Leitungen des Solargenerators möglich.

## Patentansprüche

1. Schutzschalteinrichtung für ein Solarmodul, bei dem eine Mehrzahl von zum Teil im Normalbetrieb und zur selben Zeit zum Teil im Abschattungsfall arbeitenden Solarzellen in Reihe geschaltet sind, mit mindestens einem steuerbaren elektrischen, als Bypasselement dienendes Schaltelement (1), dessen Schaltstrecke parallel zu der Mehrzahl von Solarzellen anschließbar ist, mit einer Versorgungsschaltung (50) zum Bereitstellen einer Steuerspannung zur Ansteuerung der Steuerelektrode des Bypasselementes (1) gekenzeichnet durch eine Trennschaltung (40) zum Sperren der über die Schaltstrecke des Bypasselementes im Normalbetrieb liegenden Spannung zu der Versorgungsschaltung (50) und zum Durchschalten der über die Schaltstrecke im Abschattungsfall mindestens einer Solarzelle liegenden Spannung zu der Versorgungsschaltung (50).

2. Schutzschalteinrichtung nach Anspruch 1, **dadurch gekennzeichnet, dass** die Versorgungsschaltung als Ladeschaltung (50) für einen Energiespeicher (3, 8, 60) ausgebildet ist, die eine Umsetzung der im Abschattungsfall zur Verfügung stehenden Spannung in eine zur Ansteuerung des steuerbaren Bypasselementes höhere Spannung vornimmt.

3. Schutzschalteinrichtung nach Anspruch 1 oder Anspruch 2, **dadurch gekennzeichnet, dass** das steuerbare Bypasselement (1) als MOS-Feldeffekttransistor ausgebildet ist.

4. Schutzschalteinrichtung nach Anspruch 2 oder Anspruch 3, **dadurch gekennzeichnet, dass** der Energiespeicher als Kondensator (8) und/oder als die dem steuerbaren Bypasselement (1) inhärente Kapazität (3) ausgebildet ist.

5. Schutzschalteinrichtung nach einem der Ansprüche 1 bis 4, **dadurch gekennzeichnet, dass** die Trennschaltung (40) als Feldeffekttransistor, vorzugsweise als J-FET oder als MOSFET ausgebildet ist.

6. Schutzschalteinrichtung nach einem der Ansprüche 1 bis 4, **dadurch gekennzeichnet, dass** die Trennschaltung als invers betriebener Bipolartransistor ausgebildet ist.

7. Schutzschalteinrichtung nach einem der Ansprüche 1 bis 6, **dadurch gekennzeichnet, dass** eine Zeitgeberschaltung (80) vorgesehen ist, die einen Zeitzyklus vorgibt, während dessen das steuerbare Bypasselement (1) über einen ersten Zeitbereich vollständig durchgeschaltet ist und einen zweiten Zeitbereich vollständig gesperrt ist, wobei im zweiten Zeitbereich der Energiespeicher (3, 8, 60) geladen wird.

8. Schutzschalteinrichtung nach Anspruch 7, **dadurch gekennzeichnet, dass** der Zeitzyklus einen dritten, zwischen dem ersten und dem zweiten Zeitbereich liegenden Zeitbereich aufweist, bei dem das steuerbare Bypasselement (1) im linearen Zustand betrieben wird.

9. Schutzschalteinrichtung nach einem der Ansprüche 1 bis 6, **dadurch gekennzeichnet, dass** die Versorgungs- oder Ladeschaltung (50) eine Regelschaltung (24) aufweist, mit der das steuerbare Bypasselement ständig im linearen Zustand betreibbar ist.

10. Schutzschalteinrichtung nach einem der Ansprüche 1 bis 9, **dadurch gekennzeichnet, dass** die Versorgungs- oder Ladeschaltung (50) zur Erzeugung der zur Aussteuerung des steuerbaren Bypasselements (1) benötigten Spannung einen Transformator oder mindestens eine Spule oder mindestens einen Kondensator zur Zwischenspeicherung von Energie für die Hochsetzung der im Abschaltungsfall zur Verfügung stehenden Spannung aufweist.

11. Schutzschalteinrichtung nach einem der Ansprüche 1 bis 10, **dadurch gekennzeichnet, dass** die Versorgungs- oder Ladeschaltung (50) zur Erzeugung der zur Aussteuerung des steuerbaren Bypasselements (1) benötigten Spannung eine Ladungspumpe für die Hochsetzung der im Abschaltungsfall zur Verfügung stehenden Spannung aufweist.

12. Schutzschalteinrichtung nach einem der Ansprüche 1 bis 10, **dadurch gekennzeichnet, dass** die Versorgungsschaltung (50) einen Transformator (20) mit einer Mitkopplungswicklung (22) und ein erstes elektronisches Schaltelement (24) aufweist, wobei Schaltelement und Transformator (20) ähnlich einem Sperrschwinger einen Kippvorgang ausüben, bei dem die im Transformator (20) gespeicherte Energie in den Energiespeicher (3, 8, 60) übertragen wird.

13. Schutzschalteinrichtung nach Anspruch 12, **dadurch gekennzeichnet, dass** das erste elektronische Schaltelement (24) invers betrieben wird und gleichzeitig die Trennschaltung (40) bildet.

14. Schutzschalteinrichtung nach Anspruch 12 oder Anspruch 13, **dadurch gekennzeichnet, dass** eine zusätzliche Ausgangswicklung (21') ähnliche einem Spartransformator mit der Primärwicklung (21) in Reihe geschaltet ist.

15. Schutzschalteinrichtung nach einem der Ansprüche 12 bis 14, **dadurch gekennzeichnet, dass** die Schaltstrecke des ersten Schaltelementes (24) mit der Primärwicklung (21) in Reihe liegt und die Mitkopplungswicklung (22) mit der Steuerelektrode des ersten Schaltelementes (24) verbunden ist.

16. Schutzschalteinrichtung nach einem der Ansprüche 1 bis 15, **dadurch gekennzeichnet, dass** die Steuerelektrode des steuerbaren Bypasselementes (1) mit einer ersten Entladeschaltung (80', 80'', 80''') verbunden ist, wobei die Zeitkonstante der ersten Entladeschaltung so gewählt ist, dass das Verhältnis der Zeit des Leitens des Bypasselementes (1) zu der des Nicht-Leitens groß ist, vorzugsweise >5.

17. Schutzschalteinrichtung nach Anspruch 16, **dadurch gekennzeichnet, dass** die erste Entladeschaltung einen zur inhärenten Kapazität (3) des Bypasselementes (1) und ggf. zu einem parallel zu ihr geschalteten Kondensator (8) parallel geschalteten Widerstand (81) aufweist.

18. Schutzschalteinrichtung nach einem der Ansprüche 12 bis 17, **dadurch gekennzeichnet, dass** die Versorgungsschaltung (50) eine Schnellentladeschaltung (26) aufweist, die bei Einsetzen des Kippvorgangs die inhärente Kapazität (3) und ggf. den parallel geschalteten Zusatzkondensator (8) schnell entlädt.

19. Schutzschalteinrichtung nach Anspruch 18, **dadurch gekennzeichnet, dass** die Schnellentladeschaltung ein zweites elektronisches Schaltelement (26) aufweist, dessen Steuerelektrode mit der Mitkopplungswicklung verbunden ist und dessen Schaltstrecke ausgehend von dem Anschluss der Steuerelektrode des Bypassschaltelementes (1) parallel zur Schaltstrecke des ersten elektronischen Schaltelementes (24) oder in Reihe mit demselben liegt.

20. Schutzschalteinrichtung nach Anspruch 16, **dadurch gekennzeichnet, dass** die erste Entladeschaltung (80'') als nicht-linear wirkende aktive Entladeschaltung ausgebildet ist, die oberhalb einer Schwellenspannung hochohmig und unterhalb der Schwellenspannung niederohmig ist, wobei die Schwellenspannung durch die für die vollständige Durchsteuerung des Bypassschaltelementes (1) benötigte Spannung an seiner Steuerelektrode bestimmt ist.

21. Schutzschalteinrichtung nach Anspruch 20, **dadurch gekennzeichnet, dass** die erste Entladeschaltung (80") als Schmitt-Trigger-Schaltung ausgebildet ist.

22. Schutzschalteinrichtung nach Anspruch 16, **dadurch gekennzeichnet, dass** die erste Entladeschaltung (80''') einen selbstleitenden J-FET und ein Netzwerk aus Diode (83'), Kondensator (82') und Entladewiderstand (83') aufweist, die ein Zeitglied zum periodischen Abschalten des Bypassschaltelements nach einer definierten Zeit bilden.

23. Schutzschalteinrichtung nach einem der Ansprüche 1 bis 22 **dadurch gekennzeichnet, dass** dem steuerbaren Bypassschaltelement eine Schutzschaltung (30) gegen Überspannung sowie gegenüber ungewolltes Einschalten zugeordnet ist.

24. Schutzschalteinrichtung nach einem der Ansprüche 1 bis 23, **dadurch gekennzeichnet, dass** zum Kurzschließen des Solarmoduls zum Zwecke der Inspektion oder im Brandfalle die Steuerelektroden der Bypasselemente auf eine solche Spannung gelegt wird, dass die Bypasselemente leitend geschaltet werden.

## Claims

1. A protective circuit device for a solar module, with which a plurality of solar cells, some of which operate in normal operation and some of which at the same time operate in the case of shading, are connected in series, with at least one controllable electrical switch element (1) serving as a bypass element, whose current path may be connected in parallel to the plurality of solar cells, with a supply circuit (50) for preparing a control voltage for activating the control electrode of the bypass element (1), **characterised by** a separating circuit (40) for blocking the voltage lying across the current path of the bypass element to the supply circuit (50) in normal operation, and for switching through the voltage lying across the current path of at least one solar cell to the supply voltage (50) in the case of shading.

2. A protective circuit device according to claim 1, **characterised in that** the supply circuit is designed as a charging circuit (50) for an energy storer (3, 8, 60), which carries out a conversion of the voltage available in the case of shading, into a higher voltage for the activation of the controllable bypass element.

3. A protective circuit device according to claim 1 or claim 2, **characterised in that** the controllable bypass element (1) is designed as a MOS field effect transistor.

4. A protective circuit device according to claim 2 or claim 3, **characterised in that** the energy storer is designed as a capacitor (8) and/or as the capacitance (3) inherent of the controllable bypass element (1).

5. A protective circuit device according to one of the claims 1 to 4, **characterised in that** the separating circuit (40) is designed as a field effect transistor, preferably as a J-FET or as a MOSFET.

6. A protective circuit device according to one of the claims 1 to 4, **characterised in that** the separating circuit is designed as an inversely operated bipolar transistor.

7. A protective circuit device according to one of the claims 1 to 6, **characterised in that** a timer circuit (80) is provided, which sets a timing cycle, whilst the controllable bypass element (1) is completely connected through over a first time region, and is completely blocked over a second time region, wherein the energy storer (3, 8, 60) is charged in a second time region.

8. A protective circuit device according to claim 7, **characterised in that** the time cycle comprises a third time region lying between the first and the second time region, with which the controllable bypass element (1) is operated in the linear condition.

9. A protective circuit device according to one of the claims 1 to 6, **characterised in that** the supply circuit or charging circuit (50) comprises a regulating circuit (24), with which the controllable bypass element may be continuously operated in the linear condition.

10. A protective circuit device according to one of the claims 1 to 9, **characterised in that** the supply circuit or charging circuit (50) comprises a transformer or at least one coil or at least one capacitor for the intermediate storage of energy for boosting the voltage available in the case of switch-off, for producing the voltage required for activating the controllable bypass element (1).

11. A protective circuit device according to one of the claims 1 to 10, **characterized in that** the supply circuit or charging circuit (50) comprises a charge pump for boosting the voltage available in the case of shading, for producing the voltage required for activating the controllable bypass element (1).

12. A protective circuit device according to one of the claims 1 to 10, **characterised in that** the supply circuit or charging circuit (50) comprises a transformer (20) with a positive feedback winding (22), and a first electronic switch element (24), wherein the switch element and the transformer (20) execute a rapid transition similarly to a self-blocking oscillator, with which the energy stored in the transformer (20) is transmitted into the energy storer (3, 8, 60).

13. A protective circuit device according to claim 12, **characterised in that** the first electronic switch element (24) is inversely operated, and simultaneously forms the separating circuit (40).

14. A protective circuit device according to claim 12 or 13, **characterised in that** an additional output winding (21') similar to an autotransformer is connected in series to the primary winding (21).

15. A protective circuit device according to one of the claims 12 to 14, **characterised in that** the current path of the first switch element (24) lies in series with the primary winding (21), and the positive feedback winding (22) is connected to the control electrode of the first switch element (24).

16. A protective circuit device according to one of the claims 1 to 15, **characterised in that** the control electrode of the controllable bypass element (1) is connected to a first discharge circuit (80', 80", 80'''), wherein the time constant of the first discharge circuit is selected such that the ratio of the time of the conductance of the bypass element (1) to that of non-conductance is large, preferably >5.

17. A protective circuit device according to claim 16, **characterised in that** the first discharge circuit has a resistor (81) which is connected in parallel to the inherent capacitance (3) of the bypass element (1) and, as the case may be, to a capacitor (8) connected parallel to this inherent capacitance.

18. A protective circuit device according to one of the claims 12 to 17, **characterised in that** the supply circuit (50) comprises a rapid discharge circuit (26), which with the onset of the rapid transition, rapidly discharges the inherent capacitance (3) and, as the case may be, the additional capacitor (8) connected in parallel.

19. A protective circuit device according to claim 18, **characterised in that** the rapid discharge circuit comprises a second electronic switch element (26), whose control electrode is connected to the positive feedback winding and whose current path, proceeding from the connection of the control electrode of the bypass element (1), lies parallel to the switch of the first electronic switch element (24) or in series with this.

20. A protective circuit device according to claim 16, **characterised in that** the first discharge circuit (80'') is designed as a non-linearly acting active discharge circuit which is high-impedance above a threshold voltage and is low-impedance below the threshold voltage, wherein the threshold voltage is determined by the voltage required for the complete activation of the bypass switch element (1), at its control electrode.

21. A protective circuit device according to claim 20, **characterised in that** the first discharge circuit (80'') is designed as a Schmitt-trigger circuit.

22. A protective circuit device according to claim 16, **characterised in that** the first discharge circuit (80''') comprises a self-conducting J-FET and a network of a diode (83'), capacitor (82') and discharge resistor (83') which form a time element for the periodic switching-off of the bypass switch element after a defined time.

23. A protective circuit device according to one of the claims 1 to 22, **characterised in that** a protective circuit (30) against excess voltage as well as undesired switching-on is assigned to the controllable bypass element.

24. A protective circuit device according to one of the claims 1 to 23, **characterised in that** for short circuiting the solar module for the purpose of inspection or in the case of fire, the control electrodes of the bypass elements are applied to such a voltage, that the bypass elements are conductively switched.

## Revendications

1. Dispositif de circuit de protection pour module solaire, dans lequel une pluralité de cellules solaires fonctionnant, en partie, en mode de fonctionnement normal et en même temps, en partie, en exposition ombre sont montées en série, comprenant au moins un élément de commutation électrique (1) pilotable, faisant office d'élément de dérivation, dont la section de commutation peut être connectée en parallèle avec la pluralité de cellules solaires, comprenant un circuit d'alimentation (50) pour fournir une tension de commande destinée à piloter l'électrode de commande de l'élément de dérivation (1), **caractérisé par** un sectionneur (40) pour bloquer la tension en mode de fonctionnement normal appliquée à la section de commutation de l'élément de dérivation vers le circuit d'alimentation (50) et pour commuter la tension appliquée à la section de commutation pour au moins une cellule solaire en exposition ombre vers le circuit d'alimentation (50).

2. Dispositif de circuit de protection selon la revendication 1, **caractérisé en ce que** le circuit d'alimentation se présente sous la forme d'un circuit de charge (50) pour un réservoir d'énergie (3, 8, 60), qui effectue une conversion de la tension disponible en exposition ombre en une tension plus élevée pour le pilotage de l'élément de dérivation pilotable.

3. Dispositif de circuit de protection selon la revendication 1 ou la revendication 2, **caractérisé en ce que** l'élément de dérivation pilotable (1) se présente sous la forme d'un transistor à effet de champ de type MOS.

4. Dispositif de circuit de protection selon la revendication 2 ou la revendication 3, **caractérisé en ce que** le réservoir d'énergie se présente sous la forme d'un condensateur (8) et/ou de la capacité inhérente (3) à l'élément de dérivation pilotable (1).

5. Dispositif de circuit de protection selon l'une quelconque des revendications 1 à 4, **caractérisé en ce que** le sectionneur (40) se présente sous la forme d'un transistor à effet de champ, de préférence de type J-FET ou de type MOSFET.

6. Dispositif de circuit de protection selon l'une quelconque des revendications 1 à 4, **caractérisé en ce que** le sectionneur se présente sous la forme d'un transistor bipolaire fonctionnant en sens inverse.

7. Dispositif de circuit de protection selon l'une quelconque des revendications 1 à 6, **caractérisé en ce qu'**il est prévu un circuit d'horloge (80) qui définit un temps de cycle, pendant lequel l'élément de dérivation pilotable (1) est complètement connecté pendant un premier laps de temps donné et complètement bloqué pendant un deuxième laps de temps donné, le réservoir d'énergie (3, 8, 60) étant chargé pendant ce deuxième laps de temps.

8. Dispositif de circuit de protection selon la revendication 7, **caractérisé en ce que** le temps de cycle présente un troisième laps de temps situé entre le premier et le deuxième laps de temps, au cours duquel l'élément de dérivation pilotable (1) fonctionne en régime linéaire.

9. Dispositif de circuit de protection selon l'une quelconque des revendications 1 à 6, **caractérisé en ce que** le circuit d'alimentation ou de charge (50) présente un circuit de réglage (24), à l'aide duquel l'élément de dérivation pilotable peut fonctionner constamment en régime linéaire.

10. Dispositif de circuit de protection selon l'une quelconque des revendications 1 à 9, **caractérisé en ce que** le circuit d'alimentation ou de charge (50) présente, pour générer la tension nécessaire au pilotage de l'élément de dérivation pilotable (1), un transformateur ou au moins une bobine ou au moins un condensateur pour le stockage intermédiaire d'énergie afin d'augmenter la tension disponible en cas de déconnexion.

11. Dispositif de circuit de protection selon l'une quelconque des revendications 1 à 10, **caractérisé en ce que** le circuit d'alimentation ou de charge (50) présente, pour générer la tension nécessaire au pilotage de l'élément de dérivation pilotable (1), une pompe de charge pour augmenter la tension disponible en cas de déconnexion.

12. Dispositif de circuit de protection selon l'une quelconque des revendications 1 à 10, **caractérisé en ce que** le circuit d'alimentation (50) présente un transformateur (20) possédant un enroulement de couplage (22) et un premier élément de commutation électronique (24), dans lequel l'élément de commutation et le transformateur (20) réalisent, à la manière d'un oscillateur de blocage, une opération de basculement, au cours de laquelle l'énergie stockée dans le transformateur (20) est transférée vers le réservoir d'énergie (3, 8, 60)

13. Dispositif de circuit de protection selon la revendication 12, **caractérisé en ce que** le premier élément de commutation électronique (24) fonctionne en sens inverse et constitue en même temps le sectionneur (40).

14. Dispositif de circuit de protection selon la revendication 12 ou la revendication 13, **caractérisé en ce qu'**un enroulement de sortie supplémentaire (21') est monté, à la manière d'un autotransformateur, en série avec l'enroulement primaire (21).

15. Dispositif de circuit de protection selon l'une quelconque des revendications 12 à 14, **caractérisé en ce que** la section de commutation du premier élément de commutation (24) est montée en série avec l'enroulement primaire (21) et **en ce que** l'enroulement de couplage (22) est connecté à l'électrode de commande du premier élément de commutation (24).

16. Dispositif de circuit de protection selon l'une quelconque des revendications 1 à 15, **caractérisé en ce que** l'électrode de commande de l'élément de dérivation pilotable (1) est connecté à un premier circuit de décharge (80', 80", 80"'), dans lequel la constante de temps du premier circuit de décharge est choisie de sorte que le rapport du temps de conduction de l'élément de dérivation (1) au temps de non-conduction soit grand, de préférence > 5.

17. Dispositif de circuit de protection selon la revendication 16, **caractérisé en ce que** le premier circuit de décharge présente une résistance (81) montée en parallèle avec la capacité inhérente (3) à l'élément de dérivation (1) et, le cas échéant, avec le condensateur (8) monté en parallèle avec cette résistance.

18. Dispositif de circuit de protection selon l'une quelconque des revendications 12 à 17, **caractérisé en ce que** le circuit d'alimentation (50) présente un circuit de décharge rapide (26) qui, lors du déclenchement de l'opération de basculement, décharge rapidement la capacité inhérente (3) et, le cas échéant, le condensateur supplémentaire (8) monté en parallèle.

19. Dispositif de circuit de protection selon la revendication 18, **caractérisé en ce que** le circuit de décharge rapide présente un second élément de commutation électronique (26), dont l'électrode de commande est reliée à l'enroulement de couplage et dont la section de commutation est montée, à partir du raccord de l'électrode de commande de l'élément de commutation par dérivation (1), en parallèle avec la section de commutation du premier élément de commutation électronique (24) ou en série avec ce dernier.

20. Dispositif de circuit de protection selon la revendication 16, **caractérisé en ce que** le premier circuit de décharge (80") se présente sous la forme d'un circuit de décharge actif non linéaire, qui a une haute impédance au-dessus d'une tension de seuil et une faible impédance au-dessous de la tension de seuil, dans lequel la tension de seuil est déterminée par la tension nécessaire au pilotage complet de l'élément de commutation par dérivation (1) au niveau de l'électrode de commande.

21. Dispositif de circuit de protection selon la revendication 20, **caractérisé en ce que** le premier circuit de décharge (80") se présente sous la forme d'un circuit de déclenchement de Schmitt (circuit de Schmitt Trigger).

22. Dispositif de circuit de protection selon la revendication 16, **caractérisé en ce que** le premier circuit de décharge (80"') présente un circuit JFET avec une conduction autonome et un réseau constitué d'une diode (83'), d'un condensateur (82') et d'une résistance de décharge (83'), qui forment un élément d'horloge pour la déconnexion périodique de l'élément de commutation par dérivation après un temps défini.

23. Dispositif de circuit de protection selon l'une quelconque des revendications 1 à 22, **caractérisé en ce que** l'on attribue à l'élément de commutation par dérivation pilotable un circuit de protection (30) protégeant contre les surtensions et contre les connexions involontaires.

24. Dispositif de circuit de protection selon l'une quelconque des revendications 1 à 23, **caractérisé en ce que**, pour court-circuiter le module solaire à des fins d'inspection ou en cas d'incendie, les électrodes de commande des éléments de dérivation sont soumises à une telle tension que les éléments de dérivation sont commutés en mode de conduction.
